# EUROPÄISCHE PATENTSCHRIFT

(11) **EP 3 375 047 B1**
(45) Veröffentlichungstag und Bekanntmachung des Hinweises auf die Patenterteilung: **21.08.2024**
(21) Anmeldenummer: 16793927.1
(22) Anmeldetag: 10.11.2016
(51) Int. Cl.: H01R 12/58, H01R 43/16

(54) **STECKKONTAKT UND VERFAHREN ZUR HERSTELLUNG EINES STECKKONTAKTS**
PLUG CONTACT AND METHOD FOR PRODUCING A PLUG CONTACT
CONTACT À INSÉRER ET MÉTHODE DE FABRICATION D'UN CONTACT À INSÉRER

(30) Priorität: 11.11.2015 DE 102015119473
(43) Veröffentlichungstag der Anmeldung: 19.09.2018
(73) Patentinhaber: Phoenix Contact GmbH & Co. KG, 32825 Blomberg (DE)
(72) Erfinder: GESKE, Ralf, 32816 Schieder-Schwalenberg (DE)
(74) Vertreter: Gesthuysen Patentanwälte
(86) Internationale Anmeldenummer: PCT/EP2016/077335
(87) Internationale Veröffentlichungsnummer: WO 2017/081194

(56) Entgegenhaltungen:
- DE-A1- 2 228 953
- DE-U- 1 915 571
- DE-U1- 9 417 277
- JP-U- S 582 976
- JP-U- S 582 976
- US-A1- 2015 194 752

## Beschreibung

Die Erfindung betrifft einen Steckkontakt zur elektrischen Kontaktierung einer Leiterplatte mittels Einsteckens des Steckkontakts in ein Kontaktloch der Leiterplatte, mit zwei flachen, relativ zueinander federnden Kontaktschenkeln und einem Verbindungsbereich, von dem aus sich die beiden Kontaktschenkel in Einsteckrichtung des Steckkontakts erstrecken, wobei der Steckkontakt in einem Stück aus einem metallischen Flachmaterial ausgestanzt ist. Außerdem betrifft die Erfindung auch ein Verfahren zur Herstellung eines Steckkontakts, mit zwei flachen, relativ zueinander federnden Kontaktschenkeln und einem Verbindungsbereich.

Steckkontakte zur Herstellung von elektrischen und/oder elektronischen Verbindungen zwischen Leitungen, verschiedenen Bauteilen oder dergleichen und Stromschienen sind in verschiedenen Ausführungsformen und für verschiedene Einsatzbereiche bekannt. Die Steckkontakte werden dazu in korrespondierende Aufnahmekontakte oder Buchsenelemente eingesteckt, wobei es sich bei den Aufnahmekontakten beispielsweise um entsprechende Öffnungen in Stromschienen oder dergleichen handeln kann. Die Steckkontakte selber können mit elektrischen Bauteilen verbunden oder zur Verbindung mit elektrischen Leitungen ausgebildet sein.

Für die Verbindung zwischen einer Leiterplatte und einem elektrischen Bauteil gibt es unterschiedliche Techniken, wobei sich in der Praxis vor allem das Löten und das Einpressen etabliert haben. Beide Techniken haben sich über Jahre bewährt, da sie einen guten und dauerhaften elektrischen Kontakt zwischen den Kontaktpartnern gewährleisten. Ein Nachteil sowohl des Lötens als auch des Einpressens besteht jedoch darin, dass beide Verbindungstechniken nicht reversibel sind, so dass eine einmal hergestellte Verbindung nicht - oder nur mit erhöhtem Aufwand - wieder getrennt werden kann. Darüber hinaus sind zur Herstellung der Verbindung zusätzliche Arbeitsschritte und/oder spezielle Werkzeuge erforderlich. Hier bieten Steckverbindungen, die in anderen Anwendungsbereichen seit Jahrzehnten verwendet werden, eine Alternative, da die Verbindung einfach von Hand hergestellt und darüber hinaus auch wieder getrennt werden kann, also reversibel ist.

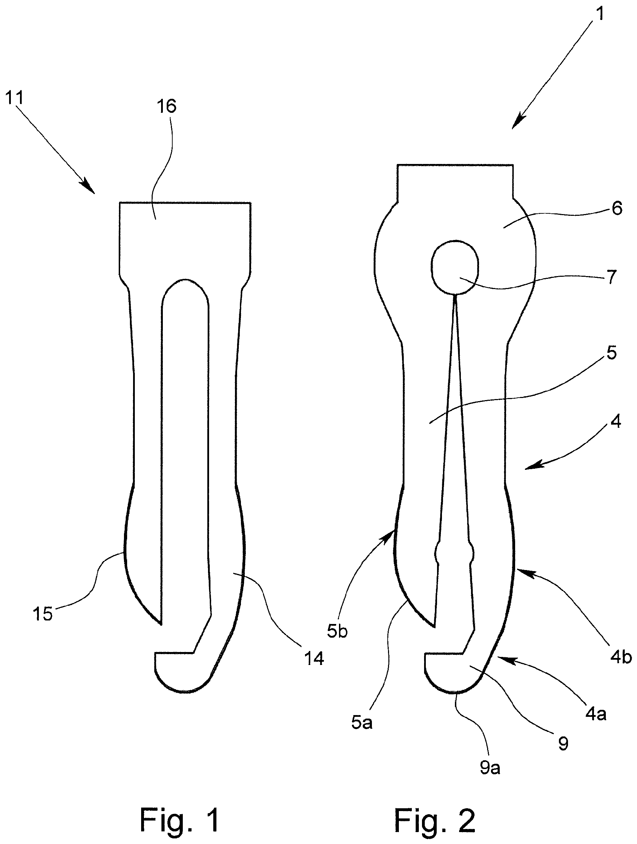

Aus der Praxis ist seit einiger Zeit ein zur Anwendung bei Leiterplatten ausgebildeter Steckkontakt bekannt, der nach Art einer Federgabel ausgebildet ist und zwei flache, relativ zueinander federnde Kontaktschenkel aufweist, die über einen gemeinsamen Verbindungsbereich miteinander verbunden sind. Bei dem bekannten Steckkontakt wird zur Herstellung der beiden Kontaktschenkel ein möglichst schmaler Bereich zwischen den Kontaktschenkeln herausgestanzt. Eine Skizze eines derartigen bekannten Steckkontakts zeigt Fig. 1.

Die US 2015/194752 A1 offenbart einen elektrischen Steckverbinder zum Einstecken in ein Kontaktlock. Der Steckverbinder umfasst zwei Schenkel, die etwa S-förmig gebogen sind. Im eingesteckten Zustand werden die beabstandeten Schenkel aneinander gepresst, wobei sich aufgrund der S-Form zwei Kontaktzonen und ergeben, an denen sich die Schenkel berühren.

Die JP S58 2976 U 10 offenbart ebenfalls einen Steckverbinder mit zwei voneinander beabstandeten Schenkeln. Nur bei Durchstecken des Steckverbinders durch das Kontaktloch berühren sich die Schenkel in ihrem Endbereich.

Die DE 2 228 953 A1 offenbart ein stiftförmiges Anschlusselement für Leiterplatten mit einem in eine Bohrung einsteckbaren Abschnitt. Das Anschlusselement ist aus einem einstückigen Stanzbiegeteil durch Aneinanderklappen zweier symmetrischer Schenkel gebildet. Die Schenkel sind V-förmig angeordnet und der einsteckbare Abschnitt wird durch Zusammendrücken der freien Schenkelenden gebildet.

Die DE 19 15 571 U offenbart ein Kontaktglied bzw. eine Lötzunge für gedruckte Verdrahtungen. Das Kontaktglied ist dabei aus einem im wesentlichen streifenförmigen, in der Längsrichtung aufgespaltenen Metallteil geformt, wobei das Metallteil in seitlicher Richtung federnd ist. Die aufgrund der Spaltung geformten Schenkel umfassen mindestens einen als Widerhaken dienenden, seitlichen Ansatz.

Damit die beiden Kontaktschenkel stanztechnisch sicher hergestellt werden können, muss ihre Breite in etwa ihrer Dicke, d. h. der Materialstärke des Flachmaterials, entsprechen, aus dem der Steckkontakt insgesamt ausgestanzt wird. Da auch die Breite des zwischen den beiden Kontaktschenkeln ausgestanzten Bereichs in etwa der Materialstärke des Flachmaterials entspricht, ergibt sich, dass die Breite der einzelnen Kontaktschenkel jeweils nur knapp 1/3 der Gesamtbreite des Steckkontakts beträgt. Die Gesamtbreite des Steckkontakts, d. h. die Breite der beiden Kontaktschenkel und die Breite des zwischen den beiden Kontaktschenkeln ausgestanzten Bereichs, wird durch den Durchmesser des Kontaktlochs in der Leiterplatte, in das der Steckkontakt eingesteckt werden soll, bestimmt. Bei kleinen Lochdurchmessern führt dies dazu, dass die Kontaktschenkel des Steckkontakts sehr schmal und dünn ausgebildet sein müssen. Dies ist zunächst stanztechnisch schwierig zu realisieren, führt darüber hinaus dazu, dass die Kontakt-Normalkraft, die von den Kontaktschenkeln aufgebracht werden kann, nur relativ gering ist.

Während bei der Einpressverbindung durch die hohen Kräfte während des Verbindungsprozesses eine gasdichte Verbindung zwischen den Kontaktpartnern entsteht, kommt es bei einer Steckverbindung nicht zu einer derartigen intermetallischen Verbindung. Bei einer Steckverbindung drücken die Kontaktpartner, d. h. der Steckkontakt und das Kontaktloch in der Leiterplatte mit der Kontakt-Normalkraft gegeneinander. Diese muss ausreichend groß sein, damit ein guter und dauerhafter elektrischer Kontakt zwischen den Kontaktpartnern gewährleistet werden kann. Sind die Kontaktschenkel zu schmal, so ist die Kontakt-Normalkraft u. U. nicht groß genug, um dauerhaft einen guten elektrischen Kontakt zu gewährleisten.

Der vorliegenden Erfindung liegt daher die Aufgabe zugrunde, einen eingangs beschriebenen Steckkontakt zur Verfügung zu stellen, der auch bei kleinen Abmessungen eine hohe Kontakt-Normalkraft ermöglicht, so dass der Steckverbinder auch bei Kontaktlöchern mit geringem Durchmesser einen guten und dauerhaften elektrischen Kontakt zwischen den Kontaktpartnern gewährleistet. Darüber hinaus soll ein Verfahren angegeben werden, gemäß dem ein entsprechender Steckkontakt möglichst einfach hergestellt werden kann.

Diese Aufgabe ist bei dem eingangs beschriebenen Steckkontakt mit den Merkmalen des Patentanspruchs 1 gelöst. Bei dem erfindungsgemäßen Stecckontakt ist im Verbindungsbereich, angrenzend an die beiden Kontaktschenkel, eine Ausnehmung ausgebildet. Außerdem weisen die beiden Kontaktschenkel ausgehend von der Ausnehmung einen in Richtung ihrer freien Enden sich vergrößernden Abstand zueinander auf, wobei die beiden Kontaktschenkel relativ zueinander einen gespreizten Zustand aufweisen. Die beiden Kontaktschenkel weisen dabei in ihrem im eingesteckten Zustand das Kontaktloch kontaktierenden Kontaktierungsbereich zusammen eine Breite auf, die gleich oder nur geringfügig kleiner als der Durchmesser des korrespondierenden Kontaktlochs in der Leiterplatte ist.

Während bei dem bekannten Steckkontakt die Breite der einzelnen Kontaktschenkel nur knapp 1/3 des Durchmessers des korrespondierenden Kontaktlochs beträgt, kann bei dem erfindungsgemäßen Steckkontakt die Breite der einzelnen Kontaktschenkel mehr als 40 % des Durchmessers des Kontaktlochs in der Leiterplatte betragen, in das der Steckkontakt eingesteckt werden soll. Dies wird bei dem erfindungsgemäßen Steckkontakt dadurch erreicht, dass der Abstand zwischen den beiden Kontaktschenkeln nicht durch Herausstanzen eines entsprechenden Materialbereichs, sondern durch Einbringen eines dünnen, messerartigen Trennschnitts zwischen den beiden Kontaktschenkeln und anschließendes Auseinanderspreizen der beiden Kontaktschenkel erzeugt wird. Der sich in Richtung der freien Enden der Kontaktschenkel vergrößernde Abstand der Kontaktschenkel zueinander wird somit durch das Auseinanderspreizen der Kontaktschenkel und nicht durch Ausstanzen eines entsprechenden Bereichs zwischen den Kontaktschenkeln erzeugt.

Die im Verbindungsbereich ausgebildete Ausnehmung, die vorzugsweise kreisförmig ist, sorgt zunächst dafür, dass der Scheitel der beiden Kontaktschenkel, d. h. der Punkt, an dem die Kontaktschenkel voneinander getrennt sind, genau festgelegt ist, unabhängig von fertigungstechnischen Toleranzen bei der Einbringung des messerartigen Trennschnitts zwischen den Kontaktschenkeln. Darüber hinaus sorgt die Ausnehmung auch dafür, dass es beim Auseinanderspreizen der beiden Kontaktschenkel nicht zu undefinierten Rissen oder Einkerbungen im Verbindungsbereich oder den Kontaktschenkeln des Steckkontakts kommt.

Gemäß einer vorteilhaften Ausgestaltung des erfindungsgemäßen Steckkontakts liegen die beiden Kontaktschenkel und der Verbindungsbereich in einer gemeinsamen Ebene, so dass der Steckkontakt insgesamt, wie auch das metallische Flachmaterial, aus dem der Steckkontakt hergestellt wird, flacher ausgebildet ist. Die Dicke des Steckkontakts entspricht dabei über der gesamten Erstreckung des Steckkontakts im Wesentlichen der Dicke des Flachmaterials. Abweichung von der einheitlichen Dicke können sich in erster Linie durch Abrundungen an den Rändern ergeben, insbesondere an der Außenkontur der Kontaktschenkel.

Gemäß einer weiteren besonders bevorzugten Ausgestaltung des erfindungsgemäßen Steckkontakts weisen die beiden Kontaktschenkel unterschiedliche Längen auf, d. h. es gibt einen ersten, längeren Kontaktschenkel und einen zweiten, kürzeren Kontaktschenkel. Am freien Ende des längeren Kontaktschenkels ist dabei ein Führungsabschnitt ausgebildet, der in Einsteckrichtung des Steckkontakts vor dem freien Ende des kürzeren Kontaktschenkels angeordnet ist. Der Führungsabschnitt dient dabei als Einführ- und Zentrierhilfe beim Einstecken des Steckkontakts in das korrespondierende Kontaktloch in einer Leiterplatte. Hierzu weist der Führungsabschnitt auf seiner den Verbindungsbereich abgewandten und damit beim Einstecken dem Kontaktloch zugewandten Seite vorzugsweise eine etwa halbkreisförmige Außenkontur auf. Beim Einstecken des Steckkontakts in das Kontaktloch gleitet somit zunächst der Führungsabschnitt des ersten, längeren Kontaktschenkels in das Kontaktloch, bevor auch der zweite, kürzere Kontaktschenkel in das Kontaktloch taucht, wobei die beiden Kontaktschenkel dann durch die Kontaktwand des Kontaktloches aufeinanderzugedrückt werden, so dass sich der Abstand zwischen den beiden Kontaktschenkeln - im Vergleich zum nicht eingesteckten Zustand - verringert.

Vorzugsweise sind die Abmessungen des Steckkontakts dabei so auf den Durchmesser des Kontaktlochs abgestimmt, dass die beiden Kontaktschenkel auch im eingesteckten Zustand noch einen geringen Abstand zueinander aufweisen, sich die beiden Kontaktschenkel somit nicht mit ihren Innenflächen vollständig berühren.

Eine weitere Ausgestaltung der Erfindung sieht vor, dass die beiden Kontaktschenkel eine sich in Längsrichtung erstreckende wellenförmige Außenkontur aufweisen. Vorzugsweise bildet dabei der Bereich des Wellenbergs der wellenförmigen Außenkontur der Kontaktschenkel den im eingesteckten Zustand das Kontaktloch kontaktierenden Kontaktierungsbereich der Kontaktschenkel. Durch die wellenförmige Außenkontur der beiden Kontaktschenkel wird das Einstecken des Steckkontakts in das Kontaktloch in der Leiterplatte erleichtert. Im gesteckten Zustand des Steckkontakts sind dann die beiden Kontaktschenkel maximal aufeinander zu gebogen, so dass die Kontakt-Normalkraft zwischen den Kontaktschenkeln und der Innenwandung des Kontaktlochs maximal ist. Beim Einstecken des Steckkontakts in das Kontaktloch ist die Stecckraft jedoch klein genug, so dass der Steckkontakt alleine - oder auch zusammen mit mehreren Steckkontakten in einem höherpoligen Stecker angeordnet - noch gut von Hand montiert werden kann.

Gemäß einer weiteren vorteilhaften Ausgestaltung des erfindungsgemäßen Steckkontakts weisen die beiden Kontaktschenkel zumindest in ihrem Kontaktbereich eine im Querschnitt abgerundete Außenkontur auf. Die Außenränder der Kontaktschenkel sind somit zumindest in dem Bereich, in dem die Kontaktschenkel im eingesteckten Zustand das Kontaktloch kontaktieren, so bearbeitet, dass sie abgerundet sind. Die Außenkontur der Kontaktschenkel kann dazu einen Radius aufweisen, der kleiner als der Radius des Kontaktloches ist. Hierdurch ist es möglich, den Steckkontakt mehrfach zu stecken und zu ziehen, ohne dass es zu größeren Beschädigungen an der Innenwandung des Kontaktloches in der Leiterplatte kommt. Ohne die vorteilhaft vorgesehene abgerundete Außenkontur können nach einigen Steckzyklen Riefen in der Wandung des Kontaktloches entstehen, durch die die Oberfläche der Wandung des Kontaktloches beschädigt werden kann.

Die zuvor genannte Aufgabe ist bei dem erfindungsgemäßen Verfahren mit den Merkmalen des Patentanspruchs 7 gelöst. Das Verfahren zur Herstellung eines Steckkontakts mit zwei flachen, relativ zueinander federnden Kontaktschenkeln und einem Verbindungsbereich weist dabei folgende Schritte auf:
- Ausstanzen einer Vorform des Steckkontakts aus einem metallischen Flachmaterial sowie Ausstanzen oder Bohren einer Ausnehmung im Verbindungsbereich
- Einbringen eines messerartigen Trennschnitts zwischen den beiden Kontaktschenkeln, wobei sich der Trennschnitt von der Ausnehmung bis zu den freien Enden der Kontaktschenkel erstreckt
- Auseinanderspreizen der beiden Kontaktschenkel.

Bei dem erfindungsgemäßen Verfahren erfolgt die Herstellung des Steckkontakts durch Ausstanzen einer Vorform des Steckkontakts aus einem metallischen Flachmaterial, wobei die Vorform des Steckkontakts noch nicht der fertigen Form des Steckkontakts entspricht. Die Vorform des Steckkontakts unterscheidet sich insbesondere dadurch von der fertigen Form des Steckkontakts, dass die beiden Kontaktschenkel noch nicht voneinander getrennt sind. Hierzu wird gemäß dem erfindungsgemäßen Verfahren nach dem Ausstanzen der Vorform des Steckkontakts ein messerartiger Trennschnitt zwischen den beiden Kontaktschenkeln eingebracht, der sich von der im Verbindungsbereich eingebrachten Ausnehmung bis zu den freien Enden der Kontaktschenkel erstreckt. Danach werden die beiden Kontaktschenkel auseinandergespreizt, wobei durch die im Verbindungsbereich ausgebildete Ausnehmung gewährleistet ist, dass beim Auseinanderspreizen der beiden Kontaktschenkel keine Risse oder Einkerbungen im Übergangsbereich zwischen dem Verbindungsbereich und den beiden Kontaktschenkeln entstehen.

Gemäß einer vorteilhaften Ausgestaltung des erfindungsgemäßen Verfahrens erfolgt das Einbringen des messerartigen Trennschnitts zwischen den beiden Kontaktschenkeln mittels eines Stanzwerkzeugs, wobei zunächst ein Kontaktschenkel relativ zum anderen Kontaktschenkel nach unten, senkrecht zur Längserstreckung der Kontaktschenkel und senkrecht zur Ebene des Steckkontakts ausgelenkt wird. Hierdurch kann ein Trennschnitt zwischen den beiden Kontaktschenkeln realisiert werden, ohne dass zwischen den beiden Kontaktschenkeln ein Bereich des Flachmaterials entfernt werden muss, wie dies bei dem aus dem Stand der Technik bekannten Steckkontakt der Fall ist. Die Trennung der beiden Kontaktschenkel führt daher nicht zu einer Reduzierung der Breite der Kontaktschenkel, wodurch ein Steckkontakt hergestellt werden kann, der auch dann noch eine ausreichend hohe Kontakt-Normalkraft aufbringen kann, wenn er für ein Kontaktloch mit einem geringen Durchmesser ausgebildet ist.

Gemäß einer weiteren bevorzugten Ausgestaltung des Verfahrens ist vorgesehen, dass die Außenkontur der im eingesteckten Zustand das Kontaktloch kontaktierenden Kontaktierungsbereiche der beiden Kontaktschenkel durch Prägen oder Schleifen abgerundet wird. Dieses Abrunden der Außenkontur der Kontaktschenkel kann dabei sowohl nach dem ersten Verfahrensschritt, d. h. nach dem Ausstanzen der Vorform des Steckkontakts als auch nach dem zweiten Verfahrensschritt, dem Einbringen des messerartigen Trennschnitts erfolgen. Darüber hinaus besteht auch die Möglichkeit, die Abrundung der Außenkontur der Kontaktbereiche der beiden Kontaktschenkel als letzten Verfahrensschritt durchzuführen, wobei dann darauf geachtet werden muss, dass die beiden Kontaktschenkel nicht aus ihrer gewollten, gespreizten Stellung zurückgebogen werden.

Im Einzelnen gibt es nunmehr eine Vielzahl von Möglichkeiten, den erfindungsgemäßen Steckkontakt sowie das erfindungsgemäße Verfahren auszugestalten und weiterzubilden. Dazu wird verwiesen sowohl auf die den Patentansprüchen 1 und 7 nachgeordneten Patentansprüche, als auch auf die nachfolgende Beschreibung in Verbindung mit der Zeichnung. In der Zeichnung zeigen
- Fig. 1: eine Darstellung eines aus dem Stand der Technik bekannten Steckkontakts, in Draufsicht,
- Fig. 2: eine entsprechende Darstellung eines erfindungsgemäßen Stecckontakts,
- Fig. 3: einen Ausschnitt einer Leiterplatte mit zwei Kontaktlöchern und zwei Steckkontakten, wobei ein Steckkontakt in ein Kontaktloch eingesteckt ist, in perspektivischer Darstellung und in Seitenansicht,
- Fig. 4: einen Ausschnitt eines in ein Kontaktloch eingesteckten Stecckontakt, in perspektivischer Darstellung,
- Fig. 5: eine vergrößerte Detaildarstellung eines in ein Kontaktloch eingesteckten Kontaktschenkels, im Querschnitt, und
- Fig. 6: den Steckkontakt in fünf aufeinander folgenden Herstellungsstufen.

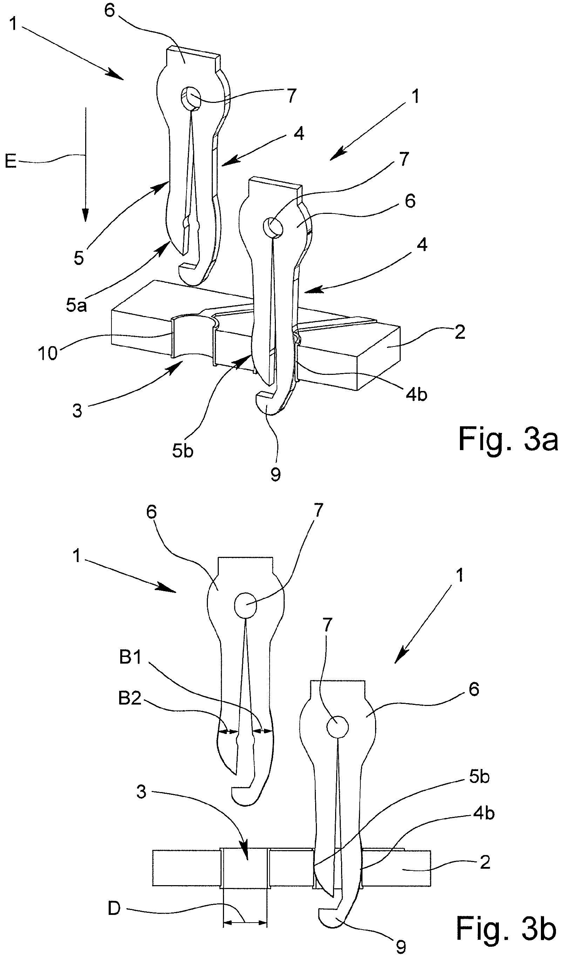

Fig. 1 zeigt einen Steckkontakt 11 gemäß dem Stand der Technik, der aus einem metallischen Flachmaterial ausgestanzt ist. Im Vergleich dazu ist in Fig. 2 ein erfindungsgemäßer Steckkontakt 1 dargestellt, wobei auch der erfindungsgemäße Steckkontakt 1 aus einem metallischen Flachmaterial ausgestanzt ist. Beide Steckkontakte 1, 11 dienen zur Kontaktierung der Leiterbahn einer Leiterplatte 2, die ausschnittsweise in Fig. 3 dargestellt ist. Hierzu wird ein Steckkontakt 1 in ein korrespondierendes Kontaktloch 3 in der Leiterplatte 2 eingesteckt.

Der in Fig. 1 dargestellte bekannte Steckkontakte 11 weist zwei Kontaktschenkel 14, 15 auf, die über einen gemeinsamen Verbindungsbereich 16 miteinander verbunden sind, wobei sich die Kontaktschenkel 14, 15 vom Verbindungsbereich 16 aus in Einsteckrichtung E des Steckkontakts 11 erstrecken. Bei dem bekannten Steckkontakt 11 werden die beiden Kontaktschenkel 14, 15 dadurch hergestellt, dass der Bereich zwischen den Kontaktschenkeln 14, 15 beim Ausstanzen des Steckkontakts 11 herausgestanzt wird. Wie aus Fig. 1 erkennbar ist, ist die Breite des zwischen den beiden Kontaktschenkeln 14, 15 ausgestanzten Bereichs etwas größer als die Breite der beiden Kontaktschenkel 14, 15. Die Breite der einzelnen Kontaktschenkel 14, 15 entspricht somit jeweils nur knapp 1/3 der Gesamtbreite des Steckkontakts 1 im eingesteckten Zustand und damit auch nur in knapp 1/3 des Durchmessers D des Kontaktlochs 3 in der Leiterplatte 2, in das der Steckkontakt 11 eingesteckt werden soll. Bei kleinen Lochdurchmessern führt dies dazu, dass die Kontaktschenkel 14, 15 des Steckkontakts 11 sehr schmal und auch sehr dünn ausgebildet sind, was dazu führt, dass die Kontakt-Normalkraft, die von den Kontaktschenkeln 14, 15 aufgebracht wird, nur relativ gering ist.

Der in den Fig. 2 bis 6 dargestellte erfindungsgemäße Steckkontakt 1 weist ebenfalls zwei Kontaktschenkel 4, 5 auf, die über einen gemeinsamen Verbindungsbereich 6 miteinander verbunden sind, wobei sich die Kontaktschenkel 4, 5 vom Verbindungsbereich 6 aus in Einsteckrichtung E des Steckkontakts 1 erstrecken. Außerdem weist der Steckkontakt 1 im Verbindungsbereich 6, angrenzend an die beiden Kontaktschenkel 4, 5 eine Ausnehmung 7 auf, die etwa kreisförmig ausgebildet ist. Ausgehend von der Ausnehmung 7 weisen die beiden Kontaktschenkel 4, 5 einen sich in Richtung ihrer freien Enden 4a, 5a vergrößernden Abstand zueinander auf, wobei die beiden Kontaktschenkel 4, 5 relativ zueinander einen gespreizten Zustand aufweisen.

Die beiden Kontaktschenkel 4, 5 weisen in ihrem Kontaktierungsbereich 4b, 5b, mit dem sie im eingesteckten Zustand das Kontaktloch 3 kontaktieren, zusammen eine Breite B auf, die nur etwas kleiner als der Durchmesser D des korrespondierenden Kontaktlochs 3 ist (vgl. Fig. 3). Dies wird bei dem erfindungsgemäßen Steckkontakt 1 dadurch ermöglicht, dass der Zwischenraum zwischen den beiden Kontaktschenkeln 4, 5 nicht durch Herausstanzen sondem durch Auseinanderspreizen der beiden, vorher durch einen messerartigen Trennschnitt 8 voneinander getrennten Kontaktschenkel 4, 5 erzeugt wird. Aus Fig. 3 ist dabei auch ersichtlich, dass die Breite B1 des ersten Kontaktschenkels 4 und die Breite B2 des zweiten Kontaktschenkels 5 im Kontaktierungsbereich 4b, 5b, jeweils mehr als 40 % des Durchmessers D des Kontaktlochs 3 beträgt. Da die Kontakt-Normalkraft, mit dem die Kontaktschenkel 4, 5 gegen die Innenwandung des Kontaktlochs 3 drücken, proportional zum Quadrat der Breite der Kontaktschenkel 4, 5 ist, führt die bei dem erfindungsgemäßen Steckkontakt 1 realisierte größere Breite der beiden Kontaktschenkel 4, 5 zu einer deutlichen Erhöhung der möglichen Kontakt-Normalkraft.

Wie aus den Figuren ersichtlich ist, weisen die beiden Kontaktschenkel 4, 5 unterschiedliche Längen auf, wobei am freien Ende 4a des längeren, ersten Kontaktschenkels 4 ein Führungsabschnitt 9 angeordnet ist, der sich in Einsteckrichtung E des Steckkontakts 1 vor dem freien Ende 5a des kürzeren Kontaktschenkels 5 befindet. Der Führungsabschnitt 9 dient als Einführ- und Zentrierhilfe beim Einstecken des Steckkontakts 1 in das korrespondierende Kontaktloch 3 einer Leiterplatte 2, wie dies insbesondere aus Fig. 3 erkennbar ist. Der Führungsabschnitt 9 weist dazu auf seiner dem Verbindungsbereich 6 abgewandten Seite 9a, die beim Einstecken dem Kontaktloch 3 zugewandt ist, eine etwa halbkreisförmige Außenkontur auf, welche beim Einstecken des Steckkontakts 1 in das Kontaktloch 3 als erstes in das Kontaktloch 3 eintaucht.

Aus Fig. 3 ist darüber hinaus ersichtlich, dass die Kontaktschenkel 4, 5 eine sich in Längsrichtung erstreckende wellenförmige Außenkontur aufweisen, wobei der Kontaktierungsbereich 4b, 5b der Kontaktschenkel 4, 5 im Bereich des Wellenbergs der wellenförmigen Außenkontur angeordnet ist.

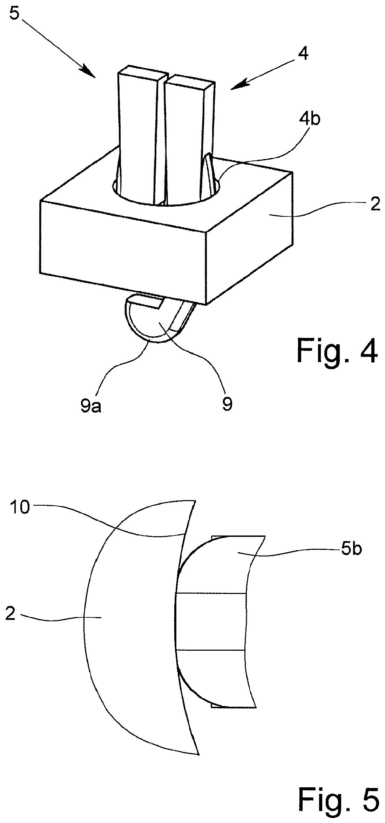

Fig. 4 zeigt einen Ausschnitt eines in ein Kontaktloch 3 einer Leiterplatte 2 eingesteckten Steckkontakts 1, bei dem die Kontaktschenkel 4, 5 zumindest im Kontaktierungsbereich 4b, 5b eine im Querschnitt abgerundete Außenkontur aufweisen, wie dies insbesondere aus der vergrößerten Detaildarstellung gemäß Fig. 5 erkennbar ist. Wie in dieser Querschnittsdarstellung eines Ausschnitts des Kontaktlochs 3 und eines an der Innenwandung 10 des Kontaktlochs 3 anliegenden Kontaktschenkels 5 erkennbar ist, ist die Außenkontur des Kontaktschenkels 5 so bearbeitet, dass die Außenkontur im Kontaktbereich 5b keine Kanten aufweist, sondern abgerundet bzw. mit einem Radius versehen ist. Dadurch ist es möglich, den Steckkontakt 1 häufiger zu stecken und zu ziehen, ohne dass es zu größeren Beschädigungen an der Innerwandung 10 des Kontaktlochs 3 in der Leiterplatte 2 kommt. So wird eine Beschädigung der die Innenwandung 10 bildenden Schicht verhindert, die zur Realisierung einer guten elektrischen Verbindung innerhalb des Kontaktlochs 3 vorgesehen ist.

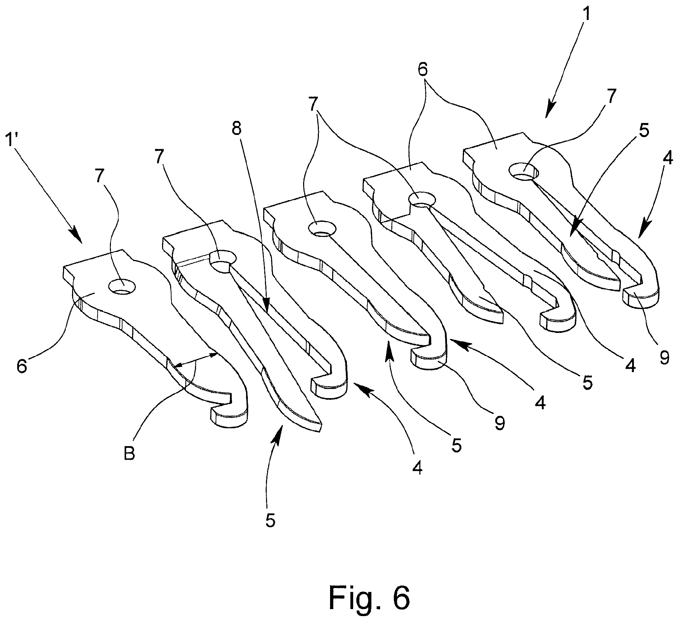

Die einzelnen Herstellungsschritte des erfindungsgemäßen Steckkontakts 1 bzw. das erfindungsgemäße Verfahren zur Herstellung des Steckkontakts 1 soll nachfolgend anhand der Fig. 6 kurz beschrieben werden, in der der Stecckontakt bzw. entsprechenden Vorformen des Steckkontakts 1 in fünf aufeinander folgenden Herstellungsstufen dargestellt ist.

In Fig. 6 ganz links ist als erste Herstellungsstufe eine Vorform 1' des Stecckontakts 1 dargestellt, die durch entsprechendes Ausstanzen aus einem metallischen Flachmaterial hergestellt worden ist. Dabei ist in dem Verbindungsbereich 6 des Steckkontakts 1 bzw. der Vorform 1' bereits eine Ausnehmung 7 ausgebildet, die mit dem Ausstanzen der Vorform 1' ausgestanzt oder separat ausgestanzt oder gebohrt sein kann.

In der zweiten Herstellungsstufe sind die beiden Kontaktschenkel 4, 5 dadurch voneinander getrennt, dass ein messerartiger Trennschnitt 8 zwischen den beiden Kontaktschenkeln 4, 5 mittels eines Stanzwerkzeugs eingebracht worden ist. Dies führt dazu, dass der Kontaktschenkel 5 relativ zum anderen Kontaktschenkel 4 nach unten, senkrecht zur Längserstreckung des Kontaktschenkels 5 und senkrecht zur Ebene des Steckkontakts 1 ausgelenkt ist, wie dies in der zweiten Abbildung von links in Fig. 6 dargestellt ist. Dabei ist auch ersichtlich, dass sich der Trennschnitt 8 von der Ausnehmung 7 bis zu den freien Enden 4a, 5a der Kontaktschenkel 4, 5 erstreckt. In dem nachfolgenden Schritt wird der zuvor nach unten ausgelenkte Kontaktschenkel 5 wieder in die Ebene des Steckkontakts 1 und damit auch in die Ebene des anderen Kontaktschenkels 4 zurückgebogen (mittlere Abbildung in Fig. 6).

In den beiden letzten Verfahrensschritten erfolgt dann das Auseinanderspreizen der beiden Kontaktschenkel 4, 5, wobei in einen ersten Schritt die Kontaktschenkel 4, 5 zunächst über ihre Endposition hinaus auseinander vorgespreizt werden. In der letzten, in Fig. 6 ganz rechts dargestellten Herstellungsstufe sind die Kontaktschenkel 4, 5 im Vergleich dazu wieder etwas aufeinander zugebogen, so dass die Breite des Steckkontakts 1 im Kontaktierungsbereich 4b, 5b der beiden Kontaktschenkel 4, 5 nur etwas größer als der Durchmesser D des Kontaktlochs 3 ist. Über die Einstellung des Abstandes zwischen den beiden Kontaktschenkeln 4, 5 kann dabei sowohl die zum Einstecken des Steckkontakts 1 in das Kontaktloch 3 erforderliche Einsteckkraft als auch die im eingesteckten Zustand zwischen den Kontaktschenkeln 4, 5 und dem Kontaktlach 3 wirkende Kontakt-Normalkraft eingestellt werden.

Dadurch, dass die beiden Kontaktschenkel 4, 5 zunächst etwas weiter als im Endzustand auseinander gespreizt und dann auf das endgültige Maß wieder etwas aufeinanderzugedrückt werden, wird die zunächst wirkende Druckspannung im Außenbereich der Kontaktschenkel 4, 5 in eine Zugspannung umgewandelt, was sich positiv auf die Federwirkung des Steckkontakts 1 auswirkt. Außerdem erfolgt dann der letzte Biegeschritt bei der Herstellung des Steckkontakts 1 in die gleiche Richtung wie die Belastung des Steckkontakts 1 im montierten Zustand, da die beiden Kontaktschenkel 4, 5 im in das Loch 3 eingesteckten Zustand aufeinander zu gedrückt werden. Auch dies ist vorteilhaft, zur Erzielung einer lang anhaltenden, hohen Kontaktkraft.

## Patentansprüche

1. Steckkontakt (1) zur elektrischen Kontaktierung einer Leiterplatte (2) mittels Einsteckens des Steckkontakts (1) in ein Kontaktloch (3) der Leiterplatte (2), mit zwei flachen, relativ zueinander federnden Kontaktschenkeln (4, 5) und einem Verbindungsbereich (6), von dem aus sich die beiden Kontaktschenkel (4, 5) in Einsteckrichtung (E) des Steckkontakts (1) erstrecken, wobei der Steckkontakt (1) in einem Stück aus einem metallischen Flachmaterial ausgestanzt ist,
wobei im Verbindungsbereich (6), angrenzend an die beiden Kontaktschenkel (4, 5), eine Ausnehmung (7) ausgebildet ist,
wobei die beiden Kontaktschenkel (4, 5) ausgehend von der Ausnehmung (7) einen in Richtung ihrer freien Enden (4a, 5a) sich vergrößernden Abstand zueinander aufweisen, wobei die beiden Kontaktschenkel (4, 5) relativ zueinander einen gespreizten Zustand aufweisen,
**dadurch gekennzeichnet, dass** die beiden Kontaktschenkel (4, 5) zusammen eine Breite (B) aufweisen, die geeignet ist, um gleich oder nur geringfügig kleiner als der Durchmesser (D) des korrespondierenden Kontaktlochs (3) in der Leiterplatte (2) zu sein, und dass die Ausnehmung (7) dafür sorgt, dass der Punkt, an dem die Kontaktschenkel (4, 5) voneinander getrennt sind, genau festgelegt ist.

2. Steckkontakt (1) nach Anspruch 1, **dadurch gekennzeichnet, dass** die beiden Kontaktschenkel (4, 5) und der Verbindungsbereich (6) in einer gemeinsamen Ebene liegen.

3. Steckkontakt (1) nach Anspruch 1 oder 2, **dadurch gekennzeichnet, dass** die beiden Kontaktschenkel (4, 5) unterschiedliche Längen aufweisen, wobei am freien Ende (4a) des längeren Kontaktschenkels (4) ein in Einsteckrichtung (E) des Steckkontakts (1) vor dem freien Ende (5a) des kürzeren Kontaktschenkels (5) angeordneter Führungsabschnitt (9) ausgebildet ist.

4. Steckkontakt (1) nach einem der Ansprüche 1 bis 3, **dadurch gekennzeichnet, dass** die beiden Kontaktschenkel (4, 5) eine sich in Längsrichtung erstreckende wellenförmige Außenkontur aufweisen.

5. Steckkontakt (1) nach Anspruch 4, **dadurch gekennzeichnet, dass** der im eingesteckten Zustand das Kontaktloch (3) kontaktierenden Kontaktierungsbereich (4b, 5b) der Kontaktschenkel (4, 5) im Bereich des Wellenbergs der wellenförmige Außenkontur der Kontaktschenkel (4, 5) angeordnet ist.

6. Steckkontakt (1) nach einem der Ansprüche 1 bis 5, **dadurch gekennzeichnet, dass** die beiden Kontaktschenkel (4, 5) zumindest in ihrem im eingesteckten Zustand das Kontaktloch (3) kontaktierenden Kontaktierungsbereich (4b, 5b) eine im Querschnitt abgerundete Außenkontur aufweisen.

7. Verfahren zur Herstellung eines Steckkontakts (1), insbesondere nach einem der Ansprüche 1 bis 6, mit zwei flachen, relativ zueinander federnden Kontaktschenkeln (4, 5) und einem Verbindungsbereich (6), **gekennzeichnet durch** die folgenden Schritte:
• Ausstanzen einer Vorform (1') des Steckkontakts (1) aus einem metallischen Flachmaterial sowie Ausstanzen oder Bohren einer Ausnehmung (7) im Verbindungsbereich (6),
• Einbringen eines messerartigen Trennschnitts (8) zwischen den beiden Kontaktschenkeln (4, 5), wobei sich der Trennschnitt (8) von der Ausnehmung (7) bis zu den freien Enden (4a, 5a) der Kontaktschenkel (4, 5) erstreckt,
• Auseinanderspreizen der beiden Kontaktschenkel (4, 5), so dass die Kontaktschenkel (4, 5) ausgehend von der Ausnehmung (7) einen in Richtung ihrer freien Enden (4a, 5a) sich vergrößernden Abstand zueinander aufweisen.

8. Verfahren nach Anspruch 7, **dadurch gekennzeichnet, dass** die Kontaktschenkel (4, 5) zunächst über ihre Endposition hinaus auseinander vorgespreizt und anschließend wieder aufeinander zugebogen werden.

9. Verfahren nach Anspruch 7 oder 8, **dadurch gekennzeichnet, dass** beim Einbringen des messerartigen Trennschnitts (8) zunächst ein Kontaktschenkel (5) relativ zum anderen Kontaktschenkel (4) senkrecht zur Längserstreckung der Kontaktschenkel (4, 5) und senkrecht zur Ebene des Steckkontakts (1) ausgelenkt wird und in einem nachfolgenden Schritt der ausgelenkte Kontaktschenkel (5) wieder in die Ebene des Steckkontakts (1) zurückgebogen wird.

10. Verfahren nach einem der Ansprüche 7 bis 9, **dadurch gekennzeichnet, dass** die Außenkontur der im eingesteckten Zustand das Kontaktloch (3) kontaktierenden Kontaktierungsbereiche (4b, 5b) der beiden Kontaktschenkel (4, 5) durch Prägen oder Schleifen abgerundet wird.

## Claims

1. A plug-in contact (1) for making electrical contact with a circuit board (2) by means of plugging the plug-in contact (1) into a contact hole (3) of the circuit board (2), with two flat contact legs (4, 5) which are resilient relative to one another, and a connecting region (6), from which the two contact legs (4, 5) extend in the plug-in direction (E) of the plug-in contact (1), wherein the plug-in contact (1) is punched in one piece out of a metallic flat material,
wherein a recess (7) is made in the connecting region (6), bordering the two contact legs (4, 5),
wherein the two contact legs (4, 5), starting from the recess (7), have a distance from one another which increases in the direction of their free ends (4a, 5a),
wherein the two contact legs (4, 5) have a spread state relative to one another,
**characterized in**
**that** the two contact legs (4, 5) together have a width (B) which is suitable of being equal to or only slightly smaller than the diameter (D) of the corresponding contact hole (3) in the circuit board (2), and
**that** the recess (7) ensures that the point at which the contact legs (4, 5) are separate from one another is defined exactly.

2. Plug-in contact (1) according to claim 1, **characterized in that** the two contact legs (4, 5) and the connecting region (6) lie in a common plane.

3. Plug-in contact (1) according to claim 1 or 2, **characterized in that** the two contact legs (4, 5) have different lengths, wherein on the free end (4a) of the longer contact leg (4) a guide section (9) is made which is located in the plug-in direction (E) of the plug-in contact (1) upstream of the free end (5a) of the shorter contact leg (5).

4. Plug-in contact (1) according to any one of claims 1 to 3, **characterized in that** the two contact legs (4, 5) have a rippled outside contour which extends in the longitudinal direction.

5. Plug-in contact (1) according to claim 4, **characterized in that** the contact-making region (4b, 5b) of the contact legs (4, 5) which makes contact with the contact hole (3) in the plugged-in state is located in the region of the crest of the rippled outside contour of the contact legs (4, 5).

6. Plug-in contact (1) according to any one of claims 1 to 5, **characterized in that** the two contact legs (4, 5) have an outside contour which is rounded in cross section at least in their contact-making region (4b, 5b) which makes contact with the contact hole (3) in the plugged-in state.

7. A method for producing a plug-in contact (1), in particular according to one of claims 1 to 6, with two flat contact legs (4, 5) which are resilient relative to one another, and one connecting region (6), **characterized by** the following steps:
- Punching a preform (1') of the plug-in contact (1) out of a metallic flat material as well as punching out or drilling a recess (7) in the connecting region (6),
- Making a blade-like separation cut (8) between the two contact legs (4, 5), the separation cut (8) extending from the recess (7) to the free ends (4a, 5a) of the contact legs (4, 5),
- Spreading the two contact legs (4, 5) apart so that the contact legs (4, 5), starting from the recess (7), have a distance from one another which increases in the direction of their free ends (4a, 5a).

8. Method according to claim 7, **characterized in that** the contact legs (4, 5) are spread apart beforehand first beyond their end position and are then again bent towards one another.

9. Method according to claim 7 or 8, **characterized in that** when the blade-like separation cut (8) is being made, first one contact leg (5) is deflected relative to the other contact leg (4) perpendicular to the longitudinal extension of the contact legs (4, 5) and perpendicular to the plane of the plug-in contact (1) and in a following step the deflected contact leg (5) is bent back again into the plane of the plug-in contact (1).

10. Method according to any one of claims 7 to 9, **characterized in that** the outside contour of the contact-making regions (4b, 5b) of the two contact legs (4, 5) which make contact with the contact hole (3) in the plugged-in state is rounded by embossing or grinding.

## Revendications

1. Contact à insérer (1) pour la mise en contact électrique d'une plaquette à circuit imprimé (2) par enfichage du contact à insérer (1) dans un trou de contact (3) de la plaquette à circuit imprimé (2), ayant deux branches de contact (4, 5) plates, élastiques l'une par rapport à l'autre, et une zone de liaison (6) à partir de laquelle les deux branches de contact (4, 5) s'étendent dans la direction d'enfichage (E) du contact à insérer (1), le contact à insérer (1) étant découpé en une pièce dans un matériau plat métallique,
un évidement (7) étant formé dans la zone de liaison (6), adjacent aux deux branches de contact (4, 5),
les deux branches de contact (4, 5) présentant, à partir de l'évidement (7), une distance mutuelle qui augmente en direction de leurs extrémités libres (4a, 5a),
les deux branches de contact (4, 5) présentant un état écarté l'une par rapport à l'autre,
**caractérisé en ce que**
les deux branches de contact (4, 5) présentent ensemble une largeur (B) qui est appropriée pour être égale ou seulement légèrement plus petite que le diamètre (D) du trou de contact (3) correspondant dans la carte de circuit imprimé (2), et
**en ce que** l'évidement (7) assure que le degré selon lequel les branches de contact (4, 5) sont séparées l'une de l'autre soit défini avec précision.

2. Contact à insérer (1), selon la revendication 1, **caractérisé en ce que** les deux branches de contact (4, 5) et la zone de liaison (6) se trouvent dans un plan commun.

3. Contact à insérer (1), selon la revendication 1 ou 2, **caractérisé en ce que** les deux branches de contact (4, 5) présentent des longueurs différentes, une section de guidage (9) disposée dans le sens d'enfichage (E) du contact à insérer (1) avant l'extrémité libre (5a) de la branche de contact plus courte (5) étant formée à l'extrémité libre (4a) de la branche de contact plus longue (4).

4. Contact à insérer (1), selon l'une des revendications 1 à 3, **caractérisé en ce que** les deux branches de contact (4, 5) présentent un contour extérieur ondulé s'étendant dans la direction longitudinale.

5. Contact à insérer (1), selon la revendication 4, **caractérisé en ce que** la zone de contact (4b, 5b) des branches de contact (4, 5) qui, à l'état enfiché, contacte le trou de contact (3), est agencée dans la zone du sommet de l'onde du contour extérieur ondulé des branches de contact (4, 5).

6. Contact à insérer (1), selon l'une des revendications 1 à 5, **caractérisé en ce que** les deux branches de contact (4, 5) présentent, au moins dans leur zone de contact (4b, 5b) en contact avec le trou de contact (3) à l'état enfiché, un contour extérieur arrondi en section transversale.

7. Procédé de fabrication d'un contact à insérer (1), en particulier selon l'une des revendications 1 à 6, avec deux branches de contact (4, 5) plates, élastiques l'une par rapport à l'autre, et une zone de liaison (6), **caractérisé par** les étapes suivantes :
• découpe d'une préforme (1') du contact à insérer (1) dans un matériau plat métallique ainsi que découpe ou perçage d'un évidement (7) dans la zone de liaison (6),
• réalisation d'une découpe de séparation (8) en forme de lame entre les deux branches de contact (4, 5), la découpe de séparation (8) s'étendant de l'évidement (7) jusqu'aux extrémités libres (4a, 5a) des branches de contact (4, 5),
• écartement des deux branches de contact (4, 5), de sorte que les branches de contact (4, 5) présentent, à partir de l'évidement (7), une distance entre elles qui augmente en direction de leurs extrémités libres (4a, 5a).

8. Procédé selon la revendication 7, **caractérisé en ce que** les branches de contact (4, 5) sont d'abord pré-écartées l'une de l'autre au-delà de leur position finale et sont ensuite à nouveau pliées l'une vers l'autre.

9. Procédé selon la revendication 7 ou la revendication 8, **caractérisé en ce que**, lors de l'introduction de la découpe de séparation (8) en forme de lame, une branche de contact (5) est d'abord déviée par rapport à l'autre branche de contact (4) perpendiculairement à l'extension longitudinale des branches de contact (4, 5) et perpendiculairement au plan du contact à insérer (1) et, dans une étape suivante, la branche de contact (5) déviée est à nouveau repliée dans le plan du contact à insérer (1).

10. Procédé selon l'une des revendications 7 à 9, **caractérisé en ce que** le contour extérieur des zones de contact (4b, 5b) des deux branches de contact (4, 5) qui, à l'état enfiché, sont en contact avec le trou de contact (3), est arrondi par estampage ou meulage.
